Europäisches Patentamt

(19) European Patent Office

Office européen des brevets

(11) Publication number: **0 196 517**
**B1**

(12) **EUROPEAN PATENT SPECIFICATION**

(45) Date of publication of patent specification: **04.07.90**

(21) Application number: **86103425.4**

(22) Date of filing: **14.03.86**

(51) Int. Cl.⁵: **H 01 L 29/205**

(54) **Compound semiconductor device.**

(30) Priority: **15.03.85 JP 52021/85**
**15.03.85 JP 52022/85**
**15.03.85 JP 52023/85**
**15.03.85 JP 52024/85**
**31.05.85 JP 119328/85**

(43) Date of publication of application:
**08.10.86 Bulletin 86/41**

(45) Publication of the grant of the patent:
**04.07.90 Bulletin 90/27**

(84) Designated Contracting States:
**DE FR GB**

(56) References cited:
**DE-A-1 614 574**

**APPLIED PHYSICS LETTERS, vol. 45, no. 8, 15th October 1984, pages 902-904, New York, US; D. ARNOLD et al.: " High performance inverted and large current double interface modulation-doped field-effect transistors with the bulk (Al,Ga)As replaced by superlattice at the inverted interface"**

(73) Proprietor: **SUMITOMO ELECTRIC INDUSTRIES LIMITED**
**No. 15, Kitahama 5-chome Higashi-ku Osaka-shi Osaka 541 (JP)**

(72) Inventor: **Matsui, Yuichi c/o Osaka Works Sumitomo Electric Ind. Ltd. 1-3, Shimaya 1-chome**
**Konohana-ku Osaka-shi Osaka-fu (JP)**

(74) Representative: **Eitle, Werner, Dipl.-Ing. et al Hoffmann, Eitle & Partner Patentanwälte Arabellastrasse 4**
**D-8000 München 81 (DE)**

(56) References cited:
**JAPANESE JOURNAL OF APPLIED PHYSICS, vol. 23, no. 8, part 2, August 1984, pages L521-L523, Tokyo, JP; T. FUKUI et al.: "(InAs)1(GaAs)1 layered crystal grown by MOCVD"**

Courier Press, Leamington Spa, England.

## Description

The present invention relates to a compound semiconductor device and more particularly to a semiconductor device having a superlattice for replacing a bulk region of the semiconductor device.

Description of the prior art

As one method of the production of compound semiconductor devices particularly of electronic devices, an epitaxial growth method is generally used partly because thin layers can be easily generated and partly because control of the elemental composition ratio in the semiconductor layer is easy. As the method of the epitaxial growth, particularly, molecular beam epitaxy growth (MBE growth) has been known. The detail thereof is described by T. Tsang in Nikkei Electronics, No. 308,163, 1983. Also, field effect transistors (FET) for use in microwave band using MBE growth are disclosed in Japanese Patent Publications 4085/1984 and 147169/1984.

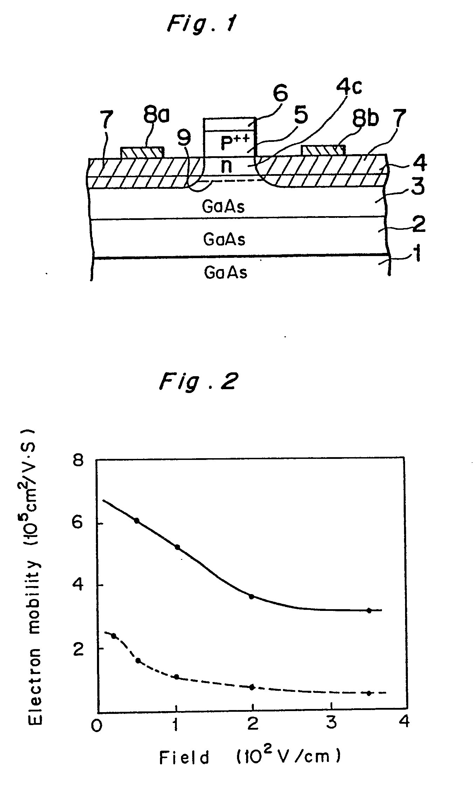

The conventional microwave FET produced using the MBE growth has a semi insulating GaAs substrate 1. A further GaAs layer 2 acting as a buffer layer is formed on the substrate as shown in Fig. 1. Undoped GaAs layer 3 is formed on the GaAs layer 2 to provide a channel layer. Electron source regions 4 with high impurity density of n-$Ga_xAl_{-6x}As$ are formed on the undoped GaAs layer 3. A layer 5 having an excessive p type impurities so as to provide a strong electron affinity is formed on the channel region 4c and a gate electrode 6 is laid on the layer 5. The regions 7 of the surface of the source regions 4 are metallized and a source electrode 8a and drain electrode 8b are formed on the metallized regions 7.

In the FET mentioned above, upon application of a suitable bias voltage to the gate electrode 6, there is generated two dimensional electron gas 9 in the channel layer 3 close to the interface between the source regions 4 and the channel layer 3. As a result, a large amount of electrons flow the area in the channel layer 3 away from the interface a few nanometers (a few tens angstroms) where the amount of ion impurities is small. Accordingly, dispersion of the ion impurities which is one of the serious factors of confining the electron mobility can be decreased.

However in the compound semiconductor device mentioned above, the electron mobility in the two dimensional electron gas strongly depends on the applied electric field, and the electron mobility decreases under high electric field. This phenomenon is described in Japanese Journal of Applied Physics 22 357, 1983, Inoue et. al. The characteristic curve in dotted line in Fig. 2 shows one example of the above mentioned phenomenon occurring in the conventional microwave FET as shown in Fig. 1. The electron dispersion in the semiconductor under a high electric field is considered due to lattice scattering caused by thermal vibration of atoms constructing the crystal structure during movement of the electrons in high speed. When the energy of the electrons increases, interruption between electrons and lattice vibration becomes large. Accordingly, when the electron energy increases by the high electric field, the electron mobility decreases.

Similarly, when the thermal vibration of atoms increases at high temperature, the electron mobility is decreased by the increase of lattice scattering.

In order to increase the electron mobility overcoming the drawbacks described above, the present inventor has studied the problems of the lattice scattering.

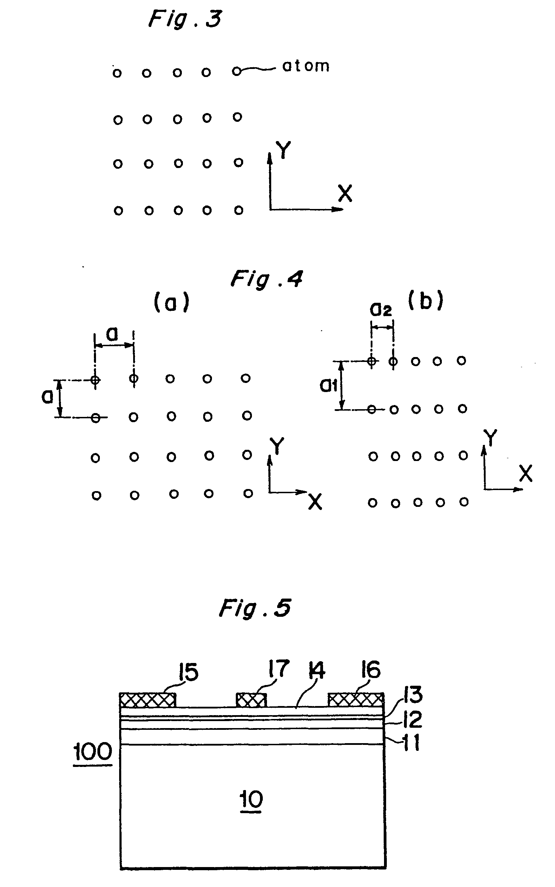

The inventor investigates that the lattice scattering or the scattering due to atomic vibration in a direction of large atomic distance as shown in Y direction in Fig. 3 is smaller than that due to atomic vibration in a direction of small atomic distance as shown in X in Fig. 3. Therefore, in the crystal structure shown in Fig. 3, the electrons can move easier in the direction X than the direction Y. That is there occurs anisotropy in the electron mobility.

Moreover, in case cubic crystal structure as shown in Fig. 4(a) changes to tetragonal crystal structure as shown in Fig. 4(b) by elastic deformation, the lattice constant $a_1$ and $a_2$ have the relations of $a_1 > a$, $a_2 < a$ (wherein a is the lattice constant of the cubic crystal before the elastic deformation occurs) as well known according to the Poisson's law.

Therefore, in the tetragonal crystal structure shown in Fig. 4(b), the electrons moving to the direction x are not easily affected by the lattice scattering compared to the electrons in the cubic crystal structure before deformation of crystal. Accordingly, the mobility in the direction X of the electrons in the tetragonal crystal is higher than the mobility of the electrons in the cubic crystal. In the conventional compound semiconductor device, effort is mainly conducted to match the lattice constant of the respective compound semiconductor layers. In the prior art, one compound semiconductor device is formed by semiconductor layers having almost the same lattice constant. Therefore, the magnitude of lattice scattering in the channel layer of the prior art compound semiconductor device is automatically confined to the lattice scattering defined by the lattice constant of the compound semiconductor forming the channel layer, whereby it is difficult to improve the problem of decreasing of the electron mobility.

On the other hand, it has been reported to grow epitaxial layers having different lattice constants without disposition or fault in the layers by adopting MBE growth or organometallic vapor phase growth. (M. J. Ludowise et. al. Applied Physics 42 (1983) or G. C. Osborn et. al. Applied Physics 41 (1982) 172).

It has been also reported that in case a compound semiconductor layer is produced as thin as the disposition or lattice defect do not occur, the crystal lattices are deformed in the tetragonal crystal at the portion adjacent to the interface of the layer due to elastic deformation. (Journal of Applied Physics 45, No. 9 (1974) 3789).

Moreover, as electron scattering mechanisms, intervalley scattering and impact ionization or phonon scattering are known. Due to such scatterings mentioned above, there are required following improvements of the semiconductor crystal for use in channel region of ultra high frequency field effect transistors (FETs).

(1) Energy difference $\triangle E$ between the valleys in the k space is relatively large so as to prevent the intervalley scattering.

(2) Energy gap Eg at $\Gamma$ point in the semiconductor crystal is relatively large so as to prevent impact ionization.

(3) The effective mass m* of the carrier electron is small so as to decrease loss of kinetic energy of the carrier electron due to phonon scattering.

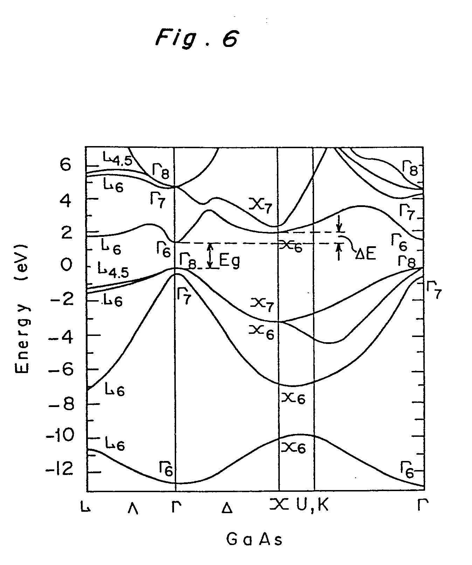

Parameters such as the intervalley energy difference $\triangle E$ and energy gap Eg of the energy band structure of GaAs crystal are shown in Fig. 6. The relation between the effective mass m* and energy band can be expressed in the following equation.

$$1/m^* = (1/h^2) \times [d^2E(k)/dk^2]$$

In the conventional compound semiconductor device, the semiconductor layers are formed with a uniform composition structure, the values $\triangle E$, Eg and m* have automatically designed. This makes a technical limit of decreasing the various scatterings mentioned above and such situation mentioned above prevents to realize high electron mobility under high electric field or high temperature in the compound semiconductor device.

In the ultra high frequency FET, the electron mobility of the compound semiconductor which is used as the channel layer of FET can be increased partly by changing the energy band structure so as to decrease the intervalley scattering under high electric field and impact ionization scattering and partly by decreasing the effective mass of the carrier electron.

On the other hand, according to LCAO theory in terms of the energy band structure of the semiconductor, the non diagonal matrix element $V_{LL'm}$ of Hamiltonian matrix which is important at the time of calculation of the energy band is expressed as

$$V_{LL'm<5s}\eta_{LL'm} \cdot h^2/m_0d^2.$$

wherein L and L' are azimuthalquantum number of the outermost p orbit of an adjacent atom constructing the crystal,

m is magnetic quantum number,

d is core interval distance between two adjacent atoms,

$m_0$ is electrom mass,

$\eta_{LL'}$ is a coefficient relating to crystal structure, and

h=h/2π (h is planck constant).

While Hamiltonian diagonal matrix elements $\varepsilon_s^c$, $\varepsilon_s^a$, $\varepsilon_m^c$, $\varepsilon_p^a$, are relating to the term value of the lone atom, wherein $\varepsilon_s^c$ is related to the term value of the plus ion atom S orbit of a polarity compound semiconductor, $\varepsilon_s^a$ to the term value of the minus ion atom S orbit, $\varepsilon_p^c$ to the term value of the plus ion atom P orbit and $\varepsilon_p^a$ to the term value of the minus ion atom P orbit.

According to this known theory mentioned above (for example, W. A. Harrison, Electronic Structure and the Property of Solids, 1980), variation of the crystal structure or atomic array which means the variation of the distance d of the two adjacent cores in the compound semiconductor crystal and variation of the kind of two adjacent atoms makes possible to vary the Hamiltonian matrix elements $V_{LL'm}$, $\varepsilon_s^a$, $\varepsilon_s^c$, $\varepsilon_p^a$ and $\varepsilon_p^c$. This means that variation of the crystal structure or atomic arrangement enables to change the energy band structure in the compound semiconductor.

The recent development of the crystal layer growth technique of the compound semiconductor, such as MBE growth or MOCVD makes it possible to grow only one atomic mono layer. In fact it has been succeeeded to grow consecutive alternate layers using GaAs and AlAs in the single atom layer basis. (A. C. Gossard, Thin Solid Films 57, 3 (1979)).

The lattice mismatch between GaAs and AlAs is about 0.3% small and the lattice strain caused by the alternate layers of these compounds is few. This means that the structure composed of alternate GaAs layer and AlAs layer is not effective to provide the crystal structure deformation, therefore the variation of the energy band structure in the layers is few.

In case the lattice mismatch is made large up to 1.5% large, there has been observed change of the energy gap Eg (G. C. Osborn et. al., Journal of Applied Physics 48 (1977) 3018). In case the lattice mismatch is relatively large as mentioned above, there occur not only the atomic arrangement but variation of the crystal structure and a relatively large variation of the energy band structure is observed.

However, in this report mentioned above, each semiconductor layer is thick as 10 to 20 nm (100 to 200 Å) and there remains undeformed crystal structure in the major part of each layer except for the minor area near the interface of the two layers of the different compounds wherein the crystal structure is deformed. As a result, the energy band of each layer is kept in the ordinary energy band defined by the cubic crystal structure of the semiconductor material used in the each layer and contribution by the deformed area to change the energy band structure is small.

The fact that the crystal lattice strain is confined only in the interface region between the two adjacent layers is reported by J. M. Brown et. al., in Applied Physics Letters 43 (1983) 863. Moreover, the fact that the crystal structure is varied by the deformation due to the lattice mismatch is reported in Journal of Applied Physics 45, No. 9, (1974) 3789.

From the foregoing, the present inventor has discovered that it is effective to form multi layers of consecutive alternate layers of three different semiconductor layers for remarkably changing the crystal structure and atomic arrangement over all the grown layers.

Still further, in the high speed mobility transistor (HEMT) as shown in Fig. 1, the channel layer on the substrate is so formed that the channel layer and the substrate have the same lattice constant and since only GaAs and/or InP are available as the semi-insulating substrate, the material for use in the channel layer of the HEMT is inherently limited.

In general, the lattice mismatching factor at the interface of the hetero junction of two materials A and B can be expressed as

$$(LP(B)-LP(A)/LP(A) \times 100\%$$

wherein LP(B) is lattice constant of material B, LP(A) is lattice constant of material A.

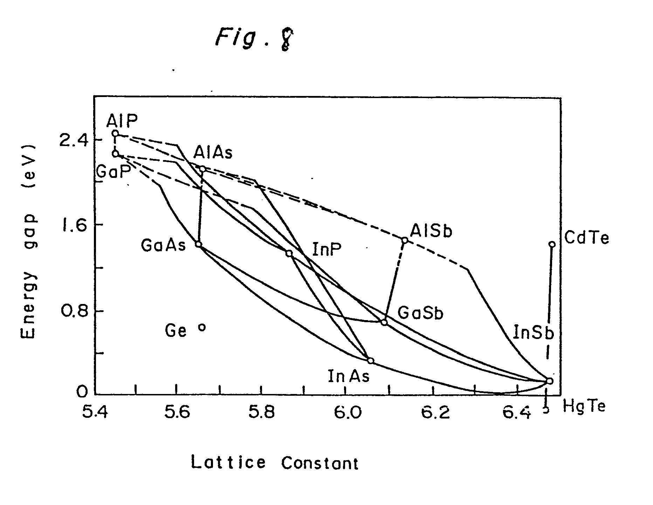

In order to grow a uniform epitaxial layer without fault in the hetero interface, it is necessary to decrease the absolute value of the lattice mismatching factor as possible as small. Therefore, once the material of the substrate is selected, the material of the compound semiconductor layer on the substrate can be also decided and it is difficult to increase the energy gap discontinuity at the hetero interface. Fig. 8 shows the relations of the energy gaps and lattice constants of the major compound semiconductors. Since there are only GaAs substrate and InP substrate are commercially available, in order to match either the lattice constant of the epitaxial layers and the substrate and the hetero interface between the channel layer and electron source layer, there are used GaAs channel layer and $Ga_xAl_{1-x}As$ or AlAs electron source layer for GaAs substrate and $In_{0.53}Ga_{0.47}As$ channel layer and $In_{0.52}Ga_{0.48}As$ electron source layer for InP substrate. However, in case the channel layer is formed of GaAs layer and the electron source layer is formed of AlAs, the energy gap discontinuity at the hetero interface is only about 0.7 eV. In case the energy gap discontinuity is small, the effect of electron confinement in the channel layer becomes small, so that the amount of the production of the two dimensional electron gas discontinuity is decreased, thereby decreasing the electron mobility. Such reduction of the electron mobility is remarkable as the temperature reaches the room temperature from a low degree.

A device according to the first part of claim 1 is known from the article by D. Arnold et. al. in Applied Physics Letters, Vol. 45, No. 8, October 1984, pages 902—904.

Summary of the invention

An essential object of the present invention is to provide a compound semiconductor device which assures high electron mobility under high electric field and high temperature.

Another object of the present invention is to provide a compound semiconductor device in which the energy band structure of each layer can be varied almost over all the effective area of the semiconductor layer to improve the electron mobility.

A further object of the present invention is to provide a compound semiconductor device which enables to prevent reduction of the effect of constraint of the electron in the two dimensional electron gas, so that high electron mobility is assured under even the room temperature.

According to the present invention, there is provided a compound semiconductor device including a superlattice for replacing a bulk region of said semiconductor device, said superlattice comprising a first semiconductor layer consisting of a first semiconductor compound having high resistivity, a second semiconductor layer consisting of a second semiconductor compound formed on the first layer for acting as a channel layer and a third semiconductor layer formed on the second layer with n-type impurity being doped therein characterized in that the third semiconductor layer consists of a third semiconductor compound and in that the second semiconductor layer has a lattice constant larger than the lattice constant of the first semiconductor layer and the third semiconductor layer has a lattice constant smaller than the second semiconductor layer so that elastic strain occurs in the crystal structure of the second semiconductor layer so that the electron mobility in a direction parallel to the interface between the second semiconductor layer and third semiconductor layer is greater than the electron mobility in a direction perpendicular to the interface.

Brief explanation of the drawings

Fig. 1 is a cross sectional view showing one example of a prior art compound semiconductor device,

Fig. 2 is a graph of characteristic curves of relation between electron mobility and electric field of the Example 1 of the present invention,

Fig. 3, Fig. 4(a) and Fig. 4(b) are schematic diagrams showing examples of atomic arrangement,

Fig. 5 is a cross section showing an embodiment of a compound semiconductor device according to the present invention,

Fig. 6 is a diagram showing the energy band structure of GaAs layer,

Fig. 7 represents an embodiment of a FET according to the present invention with a part of the multilayer enlarged,

Fig. 8 represents graphs showing relations between the energy gap and the lattice constant of various compound semiconductors,

Fig. 9 is a graph of characteristic curves of relation between electron mobility and electric field of the Example 2 of the present invention.

Detailed description of the preferred embodiments
Example 1

Referring to Fig. 5, an electric field effect transistor (referred to as FET) generally shown by 100 according to the present invention comprises a substrate 10 of GaAs semi insulator and a GaAs epitaxial layer 11 of high electric resistance (with carrier density $N=3\times10^{14}/cm^3$) formed on the substrate 10 by MBE growth. An InSb epitaxial layer 12 having carrier density $N=5\times10^{15}/cm^3$ and 20 nm (200 Å) thick is formed on the GaAs epitaxial layer 11 by MBE growth. A spacer layer 13 of $Ga_{0.7}Al_{0.3}As$ non doped n-type is formed on the InSb epitaxial layer 12 with about 5 nm (50 Å) thick by MBE growth. Finally a silicon doped $Ga_{0.7}Al_{0.3}As$ layer 14 ($N=1\times10^{17}$ to $1\times10^{18}/cm^3$) is formed on the spacer layer 13 by MBE growth.

A source electrode 15 and drain electrode 16 are formed at separated positions on the top surface of the $Ga_{0.7}Al_{0.3}As$ layer 14 so as to produce obmic contact against the $Ga_{0.7}Al_{0.3}As$ layer 14 using AuGeNi alloy. A gate electrode 17 is formed between the source electrode 15 and drain electrode 16 on the $GA_{0.7}Al_{0.3}As$ layer 14 to produce a Schottky junction using Al metal.

In the FET mentioned above, InSb has lattice constant 0.6479 nm (6.479 Å), GaAs 0.5654 nm (5.654 Å) and AlAs 0.5662 nm (5.662 Å). Accordingly, the lattice constant of InSb layer 12 is remarkably greater than the lattice constants of GaAs layer and $Ga_xAl_{1-x}As$ in which GaAs and AlAs coexist. Thus, the crystal structure in InSb layer 12 is deformed from the cubic crystal lattice into the tetragonal crystal lattice due to elastic strain near the interface between $Ga_xAl_{1-x}As$ layer and InSb layer.

In the FET structure, $Ga_{0.7}Al_{0.3}As$ layer 14 or the cap layer can be completely depleted by controlling the gate voltage applied to the gate electrode 17 and there can be provided FET in which only InSb layer 12 acts as the channel layer of FET since both of GaAs substrate 10 and GaAs epitaxial layer 11 have high resistance.

In the FET shown in Fig. 5, the electrons can be supplied from the source region below the source electrode 15 and the electrons are transferred through the channel layer 12 to the drain region. Upon controlling the gate voltage, the electrons flowing the channel layer can be controlled.

Test was conducted on a sample having the epitaxial layers as shown in Fig. 5 in terms of the relation between the electron mobility and applied electric field, and the result of the test is shown in the real line in Fig. 2. Comparing the curves plotted by the real line and dotted line, it can be seen that the electron mobility of the semiconductor device according to the present invention is greater six times than that of the prior art semiconductor device.

In the embodiment mentioned above, the thickness of InSb epitaxial layer 12 may be in the range of 2 to 20 nm (20 Å to 200 Å) thick.

In the FET of this example, the lattice constant of the InSb layer 12 acting as the channel layer is much larger than those of the GaAs layer and GaAlAs layer on both sides of the layer 12, there occurs the elastic strain in the channel layer so that the lattice scattering when the electrons flows in the direction parallel to the interface of the layers can be decreased, thereby resulting in increasing of the electron mobility in the parallel direction compared to the mobility in the direction perpendicular to the interface. Therefore, a compound semiconductor device which is able to operate in a stabilized manner under even high speed operation.

Example 2

Another example of FET can be made in the same structure as mentioned above except that the layer 12 in which the crystal lattice is subjected to the elastic strain is formed of InAs layer with the impurity density $N=5\times10^{15}/cm^3$. In the Example 2, the crystal structure in InAs layer 12 is deformed from the cubic crystal lattice into the tetragonal crystal lattice due to elastic strain near the interface between $Ga_xAl_{1-x}As$ layer and InAs layer.

In the FET structure, $GA_{0.7}Al_{0.3}As$ layer 14 or the cap layer can be completely depleted by controlling the gate voltage applied to the gate electrode 17 and there can be provided FETs in which only InAs layer 12 acts as the channel layer of FET since both of GaAs substrate 10 and GaAs epitaxial layer 11 have high resistance.

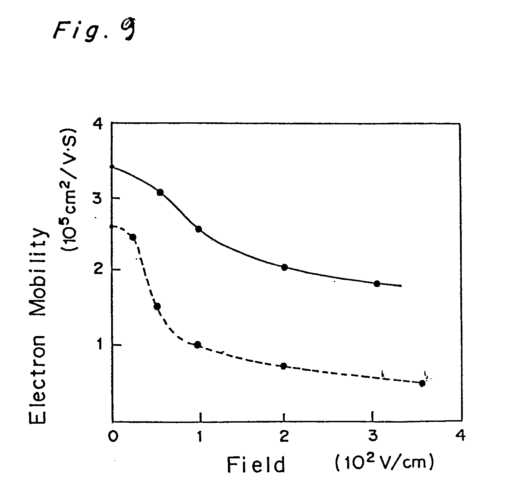

Test was conducted on a sample of the Example 2 in terms of the relation between the electron mobility and applied electric field, and the result of the test is shown in the real line in Fig. 9. Comparing the curves plotted by the real line and dotted line (prior art), it can be seen that the electron mobility of the semiconductor device according to the present invention is greater 2 times than that of the prior art semiconductor device. The FETs shown in Examples 1 and 2 are respectively provided with the elastic strained layer using the semiconductor of large lattice constant and the layers disposed on both sides of the elastic strained layer using the semiconductor of relatively small lattice constant. As the compound semiconductors having a relatively large lattice constant such as GaSb with lattice constant 0.6035 nm (6.035 Å) may be used. As the compound semiconductor having a relatively small lattice constant, GaP 0.5451 nm (5.451 Å), InP 0.5869 nm (5.869 Å) may be used. Furthermore, semiconductors of ternary or quarternary alloys may be used by combining the elements mentioned above.

Example 3

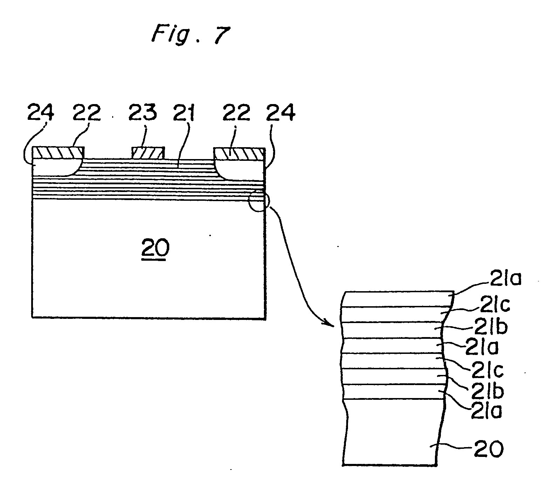

Referring to Fig. 7 showing another embodiment of the an FET according to the present invention, multi thin film layers 21 are formed on a substrate 20 made of semi insulating material such as InP. The multi thin film layers 21 are formed in such a manner that InAs semiconductor layer 21a, GaAs semiconductor layer 21b and InSb semiconductor layer 21c are alternately and consecutively formed in the form of crystal structure, each of InAs layer 21a, GaAs layer 21b and InSb layer 21c being formed by several atomic layers. In the preferred embodiment, eighty InAs layers 21a, eighty GaAs layers 21b and eighty InSb layers are respectively formed to provide the compound semiconductor multi thin film layers 21 having $In_xGa_{1-x}As_ySb_{1-y}$ acting as a channel layer of FET. In the preferred embodiment, the total thickness of the multi thin film layers 21 is 0.15 μm and each InAs layer 21a has 1 nm (10 Å) thick, GaAs layer 21b 2 nm (20 Å) thick and InSb layer 21c .35 n, (3.5 Å) thick. The multi thin film layers 21 are formed on the substrate by MBE growth.

A pair of electrodes 22 of ohmic junction using AuGeNi are formed separated each other with a predetermined distance on the top surface of the multi thin film layers 21 by metallic evaporation of AuGeNi so as to provide a source electrode and drain electrode. A Schottky junction electrode 23 is formed at the central portion between the electrodes 22 on the top surface of the channel layer 21 by evaporation to provide a gate electrode.

In the process of the evaporation of the electrodes 22 and alloying process, Au atoms are diffused in the multi thin film layers 21, whereby the periodicity of the layer structure in the multi thin film layers 21 is disturbed in the regions 24 below the electrodes 22 and the crystal structure in the regions 24 is made into the mixed structure as same as the conventional

$$In_xGa_{1-x}As_ySb_{1-y}$$

structure. As a result, the energy band structure in the regions 24 also becomes the same structure of the energy band in the conventional

$$In_xGa_{1-x}As_ySb_{1-y}$$

so that there is no obstruction to produce the ohmic junction. The phenomenon that the periodicity of the layer structure of the compound semiconductor is destroyed has been reported by N. Holonyak et. al. in Applied Physics Letters 39 (1981) 102.

The source electrode and drain electrode 22 and gate electrode 23 are respectively processed according to the conventional technique for the production of the conventional FET. It was confirmed that FET shown in Fig. 7 could fully act as an FET. It was also confirmed that in the compound semiconductor FET shown in Fig. 7, the crystal structure and energy band were quite different from those in the compound semiconductor using

$$In_xGa_{1-x}As_ySb_{1-y}$$

crystal structure by the measurements of X ray diffraction and photo absorption. In the compound semiconductor device of the Example 3, the electron mobility is increased up to five times compared to that of the semiconductor using

$$In_xGa_{1-x}As_ySb_{1-y}$$

crystal structure.

In the FET shown in the Example 3, thickness of each layer of the multi thin film layers 21 may be changed in the range between 1 atomic layer and 100 atomic layers to increase the electron mobility. According to the test, it has been found that preferably the thickness of the each thin film layer having the same components of the compound in the multi thin film layers 21 has the same thickness.

In the example 3, as the compound of the multi thin film layers 21, InAs having lattice constant 0.6058 nm (6.058 Å), GaAs of the lattiace constant 0.5654 nm (5.654 Å) and InSb of the lattice constant 0.6479 nm (6.479 Å) were used. However, the multi thin film layers 21 may be formed using various other compound semiconductors provided that there is difference of the lattice constant between two kinds of compound semiconductors more than 0.3% preferably more than 1.5%. For example, as the compound semiconductors having large lattice constant GaSb 0.6095 nm (6.095 Å) and as the compound semiconductor having small lattice constant, GaP 0.5457 nm (5.451 Å), InP 0.5869 nm (5.869 Å) may be used. Moreover, it is possible to construct the compound semiconductor layers of quarternary alloys.

In the FET of the Example 3, the energy band structure in the channel layer can be changed by changing the crystal structure or atomic arrangement, so that various kinds of scattering in the compound semiconductor can be decreased and the effective electron mass can be decreased whereby the electron mobility can be increased.

Although the present invention is described with reference to the preferred embodiments of FETs, the semiconductor multilayer structure according to the present invention may be applied to various kinds of semicondctor device.

**Claims**

1. A compound semiconductor device including a superlattice for replacing a bulk region of said semiconductor device, said superlattice comprising a first semiconductor layer consisting of a first semiconductor compound having high resistivity, a second semiconductor layer consisting of a second semiconductor compound formed on the first layer for acting as a channel layer and a third semiconductor layer formed on the second layer with n-type impurity being doped therein characterized in that the third semiconductor layer consists of a third semiconductor compound and in that the second semiconductor layer has a lattice constant larger than the lattice constant of the first semiconductor layer and the third semiconductor layer has a lattice constant smaller than the second semiconductor layer so that elastic strain occurs in the crystal structure of the second semiconductor layer so that the electron mobility in a direction parallel to the interface between the second semiconductor layer and third semiconductor layer is greater than the electron mobility in a direction perpendicular to the interface.

2. The compound semiconductor device according to claim 1, wherein thickness of each alternate compound semiconductor layer is 1 to 100 atomic layers.

3. The compound semiconductor device according to claim 1, wherein the difference of the lattice constants of the alternate compound semiconductor layers is more than 0.3%.

4. The compound semiconductor device according to claim 1, characterized in that said first layer is a GaAs semiconductor layer having a high resistivity, said second layer is an InAs layer formed on the first layer by epitaxial growth with 2 to 20 nm (20 to 200 Å) thick and said third layer is an n conductivity type layer formed on the second layer with the compound semiconductor made of $Ga_xAl_{1-x}As$.

5. The compound semiconductor device according to claim 1, characterized in that said first layer is a GaAs semiconductor layer having a high resistivity, said second layer is an InSb layer formed on the first layer by epitaxial growth with 2 to 20 nm (20 to 200 Å) thick and said third layer is an n conductivity type layer formed on the second layer with the compound semiconductor made of $Ga_xAl_{1-x}As$.

6. A compound semiconductor device according to claims 1 to 5 characterized by a source region for supplying electrons and a drain region to receive said electrons, whereby said channel layer passes said electrons from said source region to said drain region.

7. A compound semiconductor device according to claims 1 to 6 characterized in that said semiconductor device is a field effect transistor.

**Patentansprüche**

1. Verbindungshalbleiteranordnung mit einem Mehrfachraster zum Ersetzen eines Volumenbereiches der Halbleiteranordnung, wobei der Mehrfachraster eine erste aus einer ersten Halbleiterverbindung mit hohem spezifischem Widerstand bestehende Halbleiterschicht, eine zweite aus einer zweiten Halbleiterverbindung bestehende Halbleiterschicht, die auf der ersten Schicht zum Arbeiten als eine Kanalschicht gebildet ist, und eine dritte, auf der zweiten Schicht gebildete Halbleiterschicht, in der mit n-Typ-Störstoff dotiert ist, enthält, dadurch gekennzeichnet, daß die dritte Halbleiterschicht aus einer dritten Halbleiterverbindung besteht und daß die zweite Halbleiterschicht eine Gitterkonstante aufweist, die größer als die Gitterkonstante der ersten Halbleiterschicht ist, und die dritte Halbleiterschicht eine Gitterkonstante aufweist, die kleiner als die zweite Halbleiterschicht ist, so daß elastische Dehnung in der Kristallstrukter der zweiten Halbleiterschicht auftritt, so daß die Elektronenbeweglichkeit in einer Richtung parallel zur Grenzfläche zwischen der zweiten Halbleiterschicht und der dritten Halbleiterschicht größer als die Elektronenbeweglichkeit in einer Richtung quer zu der Grenzfläche ist.

2. Verbindungshalbleiteranordnung nach Aspruch 1, dadurch gekennzeichnet, daß die Dicke von jeder zweiten Verbindungshalbleiterschicht 1 bis 100 atomische Schichten ist.

3. Verbindungshalbleiteranordnung nach Anspruch 1, dadurch gekennzeichnet, daß der Unterschied zwischen den Gitterkonstanten der abwechselnden Verbindungshalbleiterschichten mehr als 0,3% ist.

4. Verbindungshalbleiteranordnung nach Anspruch 1, dadurch gekennzeichnet, daß die erste Schicht eine GaAs-Halbleiterschicht mit hohem spezifischem Widerstand, die zweite Schicht eine auf der ersten Schicht durch epitaxiales Aufwachsen mit einer Dicke von 2 bis 20 nm (20 bis 200 Å) gebildete InAs-Schicht und die dritte Schicht eine auf der zweiten Schicht gebildete n-Leitfähigkeitstypschicht mit dem Verbindungshalbleiter aus $Ge_xAl_{1-x}As$ ist.

5. Verbindungshalbleiteranordnung nach Anspruch 1, dadurch gekennzeichnet, daß die erste Schicht eine GaAs-Halbleiterschicht mit einer hohen Widerstandsfähigkeit, die zweite Schicht eine auf der ersten Schicht durch epitaxiales Aufwachsen mit einer Dicke von 2 bis 20 nm (20 bis 200 Å) gebildete InSb-Schicht und die dritte Schicht eine auf der zweiten Schicht gebildete n-Leitfähigkeitstypschicht mit dem Verbindungshalbleiter aus $Ge_xAl_{1-x}As$ ist.

6. Verbindungshalbleiteranordnung nach den Ansprüchen 1 bis 5, gekennzeichnet durch einen Quellenbereich zum Zuführen von Elektronen und einen Senkenbereich zum Empfangen der Elektronen, womit die Kanalschicht die Elektronen von dem Quellenbereich zu dem Senkenbereich leitet.

7. Verbindungshalbleiteranordnung nach den Ansprüchen 1 bis 6, dadurch gekennzeichnet, daß die Halbleiteranordnung ein Feldeffekttransistor ist.

**Revendications**

1. Dispositif semi-conducteur composite, comprenant une superstructure destinée à remplacer une région en volume du dispositif semi-conducteur, la superstructure comprenant une première couche semi-conductrice formée d'un premier composé semi-conducteur ayant une résistivé élevée, une seconde couche semi-conductrice formée d'un second composé semi-conducteur, formée sur la première couche et destinée à jouer le rôle d'une couche de canal, et une troisième couche semi-conductrice formée sur la seconde couche, une impureté de type n étant dopée dans cette couche, caractérisé en ce que la troiosième couche semi-conductrice est formée d'un troisième composé semi-conducteur, et en ce que la seconde couche semi-conductrice a une constante de réseau supérieure à celle de la première couche semi-conductrice et la troisième couche semi-conductrice a une constante de réseau inférieure à celle de la seconde couche semi-conductrice, si bien qu'une déformation élastique apparaît dans la structure cristalline de la seconde couche semi-conductrice et que la mobilité électronique, en direction parallèle à l'interface de la seconde couche semi-conductrice et de la troisième couche semi-conductrice, est supérieure à la mobilité électronique dans une direction perpendiculaire à l'interface. .

2. Dispositif semi-conducteur composite selon la revendication 1, dans lequel l'épaisseur de chacune des couches semi-conductrices qui alternent est comprise entre une et cent couches atomiques.

3. Dispositif semi-conducteur composite selon la revendication 1, dans lequel la différence entre les constantes de réseau des couches semi-conductrices qui alternent dépasse 0,3%.

4. Dispositif semi-conducteur composite selon la revendication 1, caractérisé en ce que la première couche est une couche semi-conductrice de GaAs ayant une résistivité élevée, la seconde couche est une couche de InAs formée sur la première couche par croissance épitaxiale avec une épaisseur comprise entre 2 et 20 nm (20 et 200 Å), et la troisième couche est une couche du type de conductivité n, formée sur la seconde couche, le semi-conducteur composite étant formé de $Ga_xAl_{1-x}As$.

5. Dispositif semi-conducteur composite selon la revendication 1, caractérisé en ce que la première couche est une couche semi-conductrice de GaAs ayant une résistivité élevée, la seconde couche est une couche de InSb formée sur la première couche par croissance épitaxiale, ayant une épaisseur comprise entre 2 et 20 nm (20 et 200 Å), et la troisième couche est une couche de type de conductivité n formée sur la seconde couche, le semi-conducteur composite étant formé de $Ga_xAl_{1-x}As$.

6. Dispositif semi-conducteur composite selon les revendications 1 à 5, caractérisé par une région de source destinée à fournir des électrons et une région de drain destinée à recevoir les électrons, si bien que la couche de canal transmet les électrons de la région de source à la région de drain.

7. Dispositif semi-conducteur composite selon les revendications 1 à 6, caractérisé en ce que le dispositif semi-conducteur est un transistor à effet de champ.

*Fig. 1*

*Fig. 2*

*Fig. 3*

o  o  o  o  o ～ atom

o  o  o  o  o

o  o  o  o  o    Y

o  o  o  o  o    X

*Fig. 4*

(a)

a

a

o  o  o  o  o

o  o  o  o  o

o  o  o  o  o

o  o  o  o  o    Y

X

(b)

a2

a1

o  o  o  o  o

o  o  o  o  o

o  o  o  o  o

o  o  o  o  o    Y

X

*Fig. 5*

15    17  14    16

13
12
11

100

10

2

*Fig . 6*

GaAs

Fig. 7

## Fig . 8

Fig. 9